# FASCICULE DE BREVET EUROPEEN

(11) **EP 0 542 754 B1**
(45) Date de publication et mention de la délivrance du brevet: **28.08.1996**
(21) Numéro de dépôt: 91911293.8
(22) Date de dépôt: 11.06.1991
(51) Int. Cl.: H04B 10/24

(54) **SYSTEME DE TRANSMISSION BIDIRECTIONNELLE A COMPOSANTS LASERS IDENTIQUES**
Bidirektionales übertragungssystem mit identischen Laserbauelementen
TWO-WAY COMMUNICATION SYSTEM HAVING IDENTICAL LASER COMPONENTS

(43) Date de publication de la demande: 26.05.1993
(73) Titulaire: FRANCE TELECOM, CNET (Centre National d'Etudes des Télécommunications), F-92131 ISSY LES MOULINEAUX (FR)
(72) Inventeur: AUFFRET, Réné, F-22700 Perros-Guirec (FR); CHAWKI, Mouhammad, F-22300 Lannion (FR); BERTHOU, Louis, F-22300 Rospez (FR)
(74) Mandataire: Signore, Robert
(86) Numéro de dépôt international: FR9100464
(87) Numéro de publication internationale: WO9222965

(56) Documents cités:
- EP-A- 0 330 190
- FR-A- 2 635 423
- PATENT ABSTRACTS OF JAPAN vol. 10, no. 263 (E-435)(2319) 9 Septembre 1986 & JP, A,61 089 735 ( NTT ) 7 Mai 1986.
- ELECTRONICS LETTERS. vol. 15, no. 26, 6 Décembre 1979, STEVENAGE,HERTS, GB pages 820 - 821; L. D'AURIA ET AL: 'Libido using eros : half-duplex optical link'
- ELECTRONICS LETTERS. vol. 21, no. 11, 23 Mai 1985, STEVENAGE GB pages 511 - 512; J.P. VAN DER ZIEL ET AL: '7.5 km bidirectional single-mode optical-fibre link using dual-mode InGaAsP/InP 1.3 micrometer laser detectors'.

## Description

La présente invention a pour objet un système de transmission bidirectionnelle à composants lasers identiques.

L'invention trouve une application privilégiée dans le multiplexage à division d'onde (ou WDM en abrégé pour "Wave-Division Multiplexing"). Cette technique utilise comme démultiplexeurs, des filtres optiques étroits.

Les communications optiques ont connu un essor remarquable, grâce notamment à l'avènement des lasers à semi-conducteur, qui sont des sources lumineuses faciles à moduler (en amplitude ou en fréquence).

Un système de transmission optique comprend donc classiquement un laser à semi-conducteur modulé, une ligne de transmission (comme une fibre optique) et un photorécepteur capable de démoduler le signal optique transmis par la ligne.

Récemment, ont été mis au point des photorécepteurs particulièrement adaptés à ce genre de liaisons. Il s'agit de structures lasers analogues à celles qui servent à constituer des lasers émetteurs, mais qui fonctionnent dans des conditions particulières, notamment en dessous du seuil de l'effet laser.

On pourra trouver une description de ces photorécepteurs particuliers dans :
- l'article de S. KOBAYASHI et al, intitulé "Automatic Frequency Control in a Semiconductor Laser and an Optical Amplifier" publié dans la revue "Journal of Lightwave Technology", Vol. LT-1, n° 2, June 1983, pp. 394-401,
- la demande de brevet français FR-A-2 635 423, intitulée "Procédé et dispositif de filtrage optique et de photodétection de signaux optiques modulés en intensité",
- l'article de K. MAGARI et al., intitulé "Optical Signal Selection with a Constant Gain and a Gain Bandwith by a Multielectrode DFB Laser Amplifier", publié dans la revue "Applied Physics Letters", 1987, 51, pp. 1974-1976,
- l'article de T.L. KOCH et al., intitulé "Tunable Multiple-Quantum-Well Distributed-Bragg Reflector Lasers as Tunable Narrowband Receivers", publié dans la revue "Electronics Letters", 6th July 1989, vol. 25, n° 14, pp. 890-892.

Dans l'avant dernière référence, en particulier, il est décrit un filtre optique accordable sur 20,6 GHz avec une largeur de bande de 2,9 GHz, ce filtre étant constitué par une structure semiconductrice à réaction distribuée (ou DFB en abrégé pour "Distributed Feed-Back") polarisée juste en dessous du seuil.

Dans la dernière référence, il est décrit un photorécepteur amplificateur résonant accordable (en abrégé TRAP pour "Tunable Resonant Amplifying Photodector") constitué par une structure laser du type à réflecteur de Bragg distribué (DBR en abrégé pour "Distributed-Bragg-Reflector") du genre à multipuits quantiques (en abrégé MQW pour "Multiple-Quantum-Well"). Lorsque cette structure travaille au-dessus du seuil, elle se comporte comme émetteur accordable, et lorsqu'elle est polarisée en dessous du seuil, elle est capable de recevoir et démoduler un signal optique. Une liaison à 250 Mbit/s a pu ainsi être réalisée avec deux composants identiques, l'un en amont fonctionnant en émetteur et l'autre en aval fonctionnant en récepteur.

Si les liaisons optiques obtenues avec des tels composants sont avantageuses, en ce qu'elles ne requièrent qu'un seul type de structure semiconductrice valable aussi bien en émission qu'en réception, elles présentent cependant un inconvénient, qui est celui de leur unidirectionnalité (c'est-à-dire qu'elles ne fonctionnent que dans un sens).

On connaît cependant, par le document EP-A-0 330 190, des systèmes de transmission optique bidirectionnelle comprenant deux ensembles d'émission-réception identiques fonctionnant alternativement en réception et en émission.

La présente invention perfectionne ce genre de système en prévoyant une structure particulière pour chacun des deux ensembles, qui permet, notamment, un multiplexage en longueur d'onde.

A cette fin, chacun des ensembles comprend :
- une structure laser semiconductrice avec une première et une seconde électrodes disposées côte à côte,
- un premier Té de polarisation comprenant une première branche alimentée par une première source de courant d'intensité inférieure au seuil d'émission laser et une seconde branche constituant une sortie de signal, ce premier Té étant relié à la première électrode de la structure laser,
- un second Té de polarisation comprenant une première branche alimentée par une seconde source de courant et une seconde branche alimentée par un courant de commutation et par un courant de modulation, la valeur moyenne de l'intensité totale du courant étant supérieure au seuil d'émission laser, ce second Té étant relié à la seconde électrode de la structure laser,
- des moyens de commutation aptes à appliquer alternativement le courant de commutation au second Té de polarisation de l'un des ensembles, puis au second Té de l'autre, chaque structure semiconductrice travaillant ainsi alternativement en émission (avec émission d'un faisceau laser modulé par le courant de modulation appliquée sur le second Té), et en réception (avec délivrance d'un signal démodulé sur la seconde branche du premier Té), la transmission s'effectuant ainsi alternativement dans un sens et dans l'autre et étant ainsi bidirectionnelle.

De préférence, la structure semi-conductrice employée est du type à réaction distribuée (DFB).

La modulation utilisée est soit une modulation d'amplitude soit une modulation de fréquence.

De toute façon, les caractéristiques de l'invention apparaîtront mieux à la lumière de la description qui va suivre. Cette description porte sur des exemples de réalisation donnés à titre explicatif et non limitatif et elle se réfère à des dessins annexés sur lesquels :
- la figure 1 montre la structure du système bidirectionnel de l'invention ;
- la figure 2 représente schématiquement les deux phases de fonctionnement ;
- la figure 3 montrent différents signaux apparaissant sur diverses entrées-sorties du système ;
- la figure 4 montre un signal de modulation et un signal de réception.

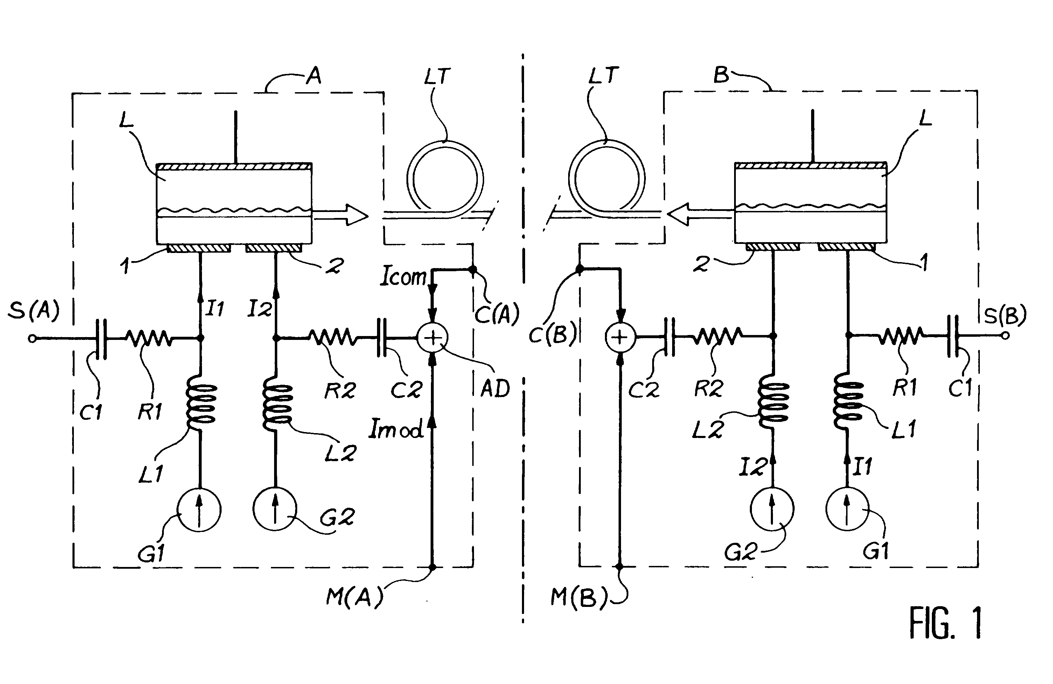

Le système représenté sur la figure 1 comprend une ligne de transmission optique LT, constitué par exemple par une fibre optique monomode, et deux ensembles A et B identiques placés respectivement aux deux extrémités de la ligne LT.

Chacun de ces ensembles comprend d'abord une structure laser semiconductrice L munie d'une première électrode 1 et d'une seconde électrode 2 disposées côte à côte. Chaque ensemble comprend encore deux Tés de polarisation :
- un premier Té comprenant une première branche formée d'une inductance L1 alimentée par une première source de courant G1 d'intensité I1 inférieure au seuil d'émission laser et une seconde branche formée d'une résistance R1 et d'un condensateur C1, cette seconde branche constituant une sortie de signal (S(A) pour l'ensemble A et S(B) pour l'ensemble B), ce premier Té étant relié à la première électrode 1 de la structure laser ;
- un second Té comprenant une première branche formée d'une inductance L2 alimentée par une seconde source de courant G2 et une seconde branche formée d'une résistance R2 et d'un condensateur C2, cette seconde branche recevant un courant de commutation Icom et un courant de modulation Imod ; dans l'exemple illustré, le courant de commutation est appliqué par une entrée de commutation (respectivement C(A) et C(B)) et le courant de modulation est appliqué sur une entrée de modulation (respectivement M(A), M(B)) ; ces deux courants sont ajoutés dans un additionneur AD ; la valeur moyenne I2 de l'intensité totale du courant est supérieure au seuil d'émission laser (quand il fonctionne en émetteur) ; ce second Té est relié à la seconde électrode de la structure laser.

Le courant de commutation Icom est appliqué alternativement à l'un des seconds Tés de polarisation puis à l'autre, et cela par les entrées de commutation C(A), C(B) reliées aux secondes branches des Tés associés. Chaque structure semiconductrice travaille ainsi alternativement comme émetteur (avec émission d'un faisceau laser modulé par le courant de modulation appliquée sur l'entrée M(A), resp. M(B)) et comme récepteur (avec délivrance d'un signal démodulé à la sortie S(A), resp. S(B) reliée à la seconde branche du premier Té).

La transmission de l'information s'effectue ainsi alternativement dans un sens puis dans l'autre : la liaison est bidirectionnelle.

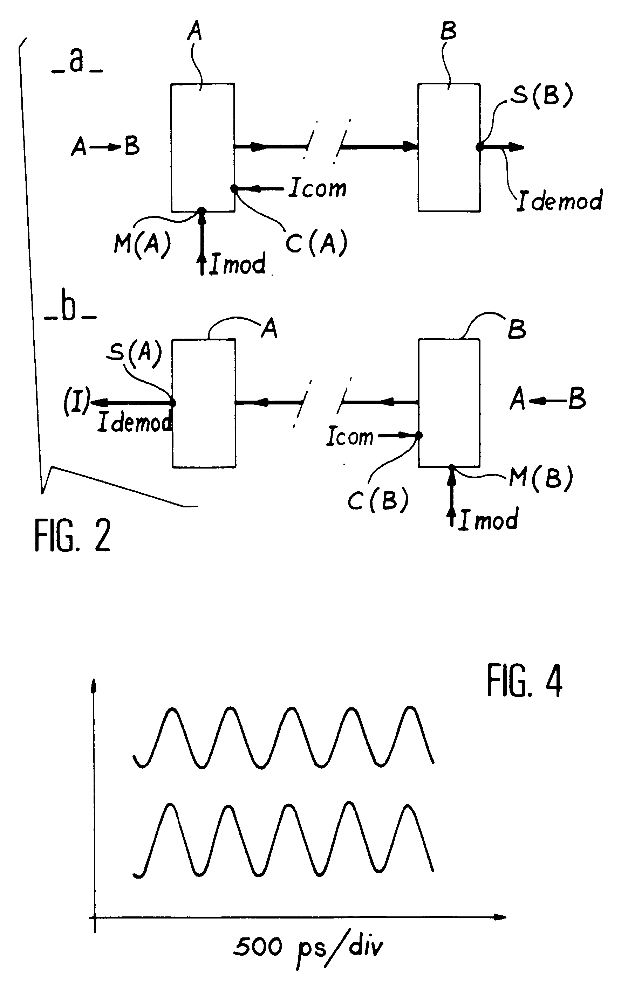

Ce fonctionnement, dit à l'alternat, est schématisé sur la figure 2 où sont représentées les deux phases alternées :
a) Transmission de A vers B (partie a) :
   L'ensemble A reçoit sur son entrée de modulation M(A) un courant Imod modulé par l'information à transmettre, et ce même ensemble reçoit un courant de commutation Icom sur son entrée C(A). Il fonctionne donc en émetteur. De son côté, l'ensemble B fonctionne en récepteur et délivre sur sa sortie S(B) un courant Idémod qui restitue l'information.
b) Transmission de B vers A (partie b) :
   C'est l'ensemble B qui reçoit sur son entrée de modulation M(B) un courant modulé Imod par l'information à transmettre et un courant de commutation Icom sur son entrée C(B). Il fonctionne donc en émetteur. L'ensemble A se comporte, lui, en récepteur et délivre sur sa sortie S(A), un courant Idémod qui restitue l'information.

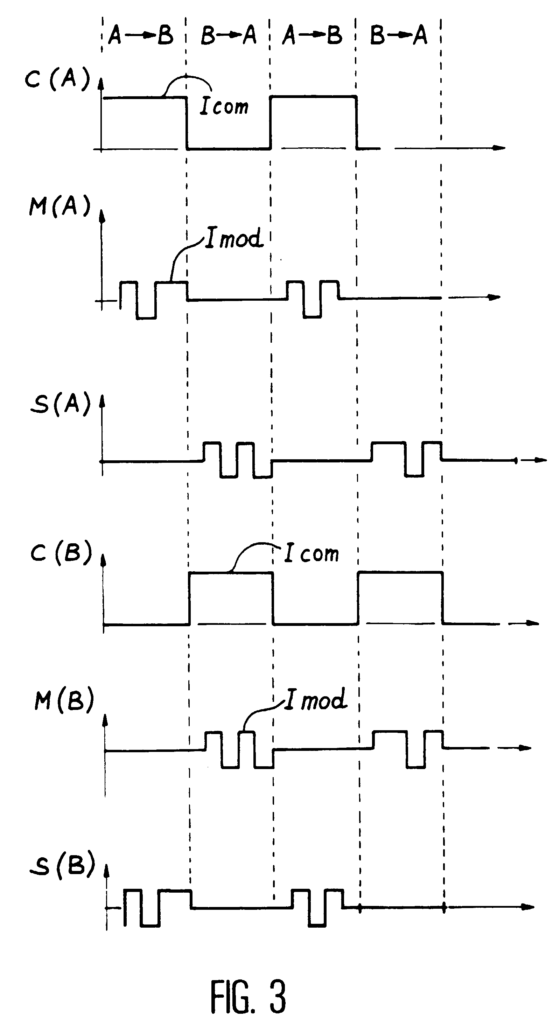

Sur la figure 3, on voit l'allure des signaux apparaissant respectivement sur l'entrée de commutation C(A) (ligne supérieure), l'entrée de modulation M(A), la sortie S(A) de l'ensemble A, l'entrée de commutation C(B), l'entrée de modulation M(B) et finalement sur la sortie S(B) de l'ensemble B (dernière ligne). La figure 3 montre ces signaux alternativement pour une transmission allant de A vers B, puis de B vers A, puis de A vers B, etc...

Le courant appliqué sur l'électrode 2, dans la phase d'émission, est la somme du courant de commutation Icom et du courant de modulation Imod, somme dont la valeur moyenne est supérieure au seuil de l'effet laser.

Dans les exemples illustrés, le courant de modulation Imod est supposé modulé en binaire par des créneaux de durée variable.

Pour illustrer les performances obtenues avec un système conforme à l'invention, il peut être indiqué que les Demandeurs ont utilisé une structure laser en GaInAsP sur InP émettant à 1,515 µm. La structure était du type à réaction distribuée (DFB) et à ruban enterré (BRS pour "Buried Ridge Structure").

De telles structures peuvent être réalisées par MOCVD (pour Metalo-Organic Chemical Vapor Deposition) conformément à une technique décrite dans l'article intitulé "Ultra-Low Threshold, High-Band with Very Low Noise Operation of 1.52 µm GaInAsP/InP DFB BRS Laser Diodes Entirely Grown by MOCVD" publié par M. KRAKOWSKI et al. dans la revue "IEEE Journal of Quantum Electronics", 1989, 25, pp. 1346-1352.

Les électrodes des structures avaient des longueurs de 200 et 300 µm chacune.

En réception, la structure laser fonctionne juste en dessous du seuil, à savoir aux environs de 10 mA. La structure semiconductrice considérée comme filtre optique, posséde une largueur de bande à mi-hauteur (FWHM pour "Full Width Half Maximum") de l'ordre de 5 GHz. La bande de transmission s'élargit lorsqu'augmente la puissance optique injectée et elle présente une asymétrie avec une chute brutale vers les hautes fréquences et un décalage vers le rouge. La réponse du laser détecteur en modulation de fréquence est uniforme sur 1 GHz et diminue de 3 dB à 1,5 GHz.

En émetteur, la structure travaille au-dessus du seuil avec des courants supérieurs à 50 mA. Le courant de modulation est de 4 mA crête à crête et conduit à une excursion de fréquence d'environ 2 GHz.

La figure 4 montre une onde sinusoïdale (ligne supérieure) correspondant à un courant de modulation à 1 GHz appliqué sur l'émetteur et (ligne inférieure) le courant délivré sur la sortie du récepteur. Ce diagramme est obtenu aussi bien dans un sens que dans l'autre.

Pour accorder les structures en longueur d'onde, il convient d'ajuster les courants du récepteur et les courants de l'émetteur. Ainsi pour obtenir, dans le sens aller, une même longueur d'onde de 1,5184 µm à l'émission et à la réception, les Demandeurs ont appliqué sur la structure fonctionnant en émetteur des courants I1= 5mA, I2= 48mA et simultanément, sur la structure fonctionnant en récepteur des courants I1= 10,3mA et I2= 58mA.

Dans le sens retour, pour un fonctionnement à 1,5201 µm, ils ont appliqué sur le laser émetteur un courant I1 de 22,6mA et un courant I2 de 58mA et, sur le laser récepteur, un courant I1 de 5mA et un courant I2 de 22mA.

Naturellement, le système qui vient d'être décrit peut fonctionner en multiplexage en longueur d'onde avec plusieurs émetteurs réglés sur plusieurs longueurs d'onde et plusieurs récepteurs réglés pour filtrer les longueurs d'onde correspondantes.

## Revendications

1. Système de transmission bidirectionnelle comprenant :
- une ligne de transmission optique (LT),
- deux ensembles (A, B) d'émission-réception identiques disposés respectivement aux deux extrémités de la ligne, et fonctionnant alternativement en réception et en émission ce système étant caractérisé par le fait que les deux ensembles comprennent :
- une structure laser semi-conductrice (L) avec une première (1) et une seconde (2) électrodes disposées côte à côte,
- un premier Té de polarisation comprenant une première branche (L1) alimentée par une première source de courant (G1) d'intensité (I1) inférieure au seuil d'émission laser et une seconde branche (R1) constituant une sortie de signal, ce premier Té étant relié à la première électrode (1) de la structure laser,
- un second Té de polarisation comprenant une première branche (L2) alimentée par une seconde source de courant (I2) et une seconde branche (R2, L2) alimentée par un courant de commutation (Icom) et par un courant de modulation (Imod), la valeur moyenne de l'intensité totale du courant étant supérieure au seuil d'émission laser, ce second Té étant relié à la seconde électrode de la structure laser,
- le courant de commutation (Imod) étant appliqué alternativement au second Té de polarisation de l'un des ensembles, puis au second Té de l'autre, chaque structure semi-conductrice travaillant ainsi alternativement en émission, et en réception.

2. Système selon la revendication 1, caractérisé par le fait que chaque structure laser semi-conductrice est du type à réaction distribuée (DFB).

3. Système selon la revendication 1, caractérisé par le fait que chaque second Té de polarisation comprend, dans sa seconde branche, un additionneur (AD) à deux entrées reliées, l'une, à une entrée de commutation (C(A), C(B)) et l'autre, à une entrée de modulation (M(A), M(B)).

## Patentansprüche

1. Bidirektionales Übertragungssystem, umfassen:
- eine optische Übertragungsleitung (LT),
- zwei identische Sende-Empfänger-Anordnungen (A, B), die an den Leitungsenden angeordnet sind und alternativ im Empfang- und im Sendebetrieb arbeiten,
**dadurch gekennzeichnet**, daß die beiden Anordnungen aufweisen:
einen Halbleiter-Laseraufbau (L) mit einer ersten (1) und einer zweiten (2) Elektrode, die Seite an Seite angeordnet sind,
ein erstes Polarisations-T-Glied mit einem ersten Zweig (L1), der von einer ersten Stromquelle (G1) gespeist wird, deren Stärke (I1) unterhalb der Laserschwelle liegt, und mit einem zweiten Zweig (R1), der einen Signalausgang bildet, wobei dieses erste T-Glied an die erste Elektrode (1) der Laseranordnung angeschlossen ist,
- ein zweites Polarisations-T-Glied mit einem ersten Zweig (L2), der von einer zweiten Stromquelle (G2) gespeist wird und mit einem zweiten Zweig (R2, L2), der von einem Umschaltstrom (Icom) und einem Modulationsstrom (Imod) gespeist wird, wobei die mittlere Gesamtstromstärke oberhalb der Laserschwelle liegt und dieses zweite T-Glied an die zweite Elektrode der Laseranordnung angeschlossen ist, wobei der Umschaltstrom (Imod) abwechselnd an das zweite Polarisations-Glied der einen der Anordnungen und dann an das zweite T-Glied der anderen Anordnung angelegt wird, wodurch jeder Halbleiteraufbau abwechselnd entweder im Sendebetrieb oder im Empfangsbetrieb arbeitet.

2. System nach Anspruch 1, **dadurch gekennzeichnet**, daß jeder Halbleiter-Laseraufbau vom Typ mit verteilter Reaktion (DFB) ist.

3. System nach Anspruch 1, **dadurch gekennzeichnet**, daß jedes zweite Polarisation-T-Glied in seinem zweiten Zweig einen Addierer (AD) mit zwei Eingängen aufweist, von denen der eine mit einem Umschalteingang (C(A), C(B)) und der andere mit einem Modulationseingang (M(A), M(B)) verbunden ist.

## Claims

1. Bidirectional transmission system comprising an optical transmissionline (LT), two identical emission-reception assemblies (A,B,) respectively located at the two ends of the line and operating alternately in reception and emission, said system being characterized in that the two assemblies comprise:
a semiconductor laser structure (L) with a first (1) and a second (2) juxtaposed electrodes,
a first polarization tee having a first branch (L1) supplied by a first current source (G1) of intensity (I1) below the laser emission threshold and a second branch (R1) constituting a signal output, said first tee being connected to the first electrode (1) of the laser structure,
a second polarization tee having a first branch (L2) supplied by a second current source (I2) and a second branch (R2, L2) supplied by a switching current (Icom) and by a modulating current (Imod), the mean value of the total intensity of the current exceeding the laser emission threshold, said second tee being connected to the second electrode of the laser structure,
the switching current (Imod) being alternately applied to the second polarization tee of one of the assemblies and then to the second tee of the other, said semiconductor structure thus operating alternately in emission and in reception.

2. System according to claim 1, characterized in that each semiconductor laser structure is of the distributed feedback type (DFB).

3. System according to claim 1, characterized in that the second polarization tee comprises, in its second branch, an adder (AD) having two inputs connected on the one hand to a switching input (C(A), C(B)) and on the other to a modulating input (M(A), M(B)).
